# FASCICULE DE BREVET EUROPEEN

(11) **EP 3 878 099 B1**
(45) Date de publication et mention de la délivrance du brevet: **13.05.2026**
(21) Numéro de dépôt: 19801246.0
(22) Date de dépôt: 04.11.2019
(51) Int. Cl.: H03K 17/96

(54) **COMPOSANT DE CAPTEUR, CAPTEUR ET APPAREIL ELECTRIQUE ELECTROMENAGER**
SENSORKOMPONENTE, SENSOR UND ELEKTRISCHES HAUSHALTSGERÄT
SENSOR COMPONENT, SENSOR AND ELECTRIC HOUSEHOLD APPLIANCE

(30) Priorité: 08.11.2018 FR 1871412
(43) Date de publication de la demande: 15.09.2021
(73) Titulaire: SEB S.A., 69130 Ecully (FR)
(72) Inventeur: LECERF, Joël, 50190 Periers (FR)
(74) Mandataire: SEB Développement
(86) Numéro de dépôt international: PCT/EP2019/080042
(87) Numéro de publication internationale: WO 2020/094545

(56) Documents cités:
- EP-A1- 2 209 212
- EP-A1- 2 355 117
- EP-A1- 2 355 117
- EP-A1- 2 837 721
- CN-U- 202 818 265

## Description

La présente invention concerne de manière générale un composant de capteur, un capteur de détection et un appareil électrique électroménager comprenant un tel capteur équipé du composant de capteur.

### Domaine technique de l'invention

En particulier, l'invention concerne un composant de capteur pour un capteur de détection d'un contact ou d'une proximité entre un membre d'un utilisateur et une portion de commande (autrement appelée surface tactile) d'un appareil électrique électroménager. En d'autres termes, l'invention concerne un composant de capteur pour un capteur tactile d'appareil électrique électroménager.

### État de la technique

Il est connu dans l'art antérieur des capteurs de détection de contact ou de proximité, comprenant typiquement une carte électronique et un ressort métallique agencé entre la carte électronique et une portion de commande de l'appareil à toucher par l'utilisateur. Le ressort métallique peut présenter plusieurs configurations dont une configuration qui permet de disposer une source lumineuse sur la carte électronique de manière centrée avec le ressort métallique de manière à éclairer la portion de commande. Néanmoins, ce système avec cette configuration de ressort présente notamment l'inconvénient de nécessiter un routage particulier des pistes de circuit imprimé sur la carte électronique pour d'une part éviter les contacts et court-circuit avec le ressort métallique, et d'autre part pour libérer de l'espace sur la carte électronique pour placer la source lumineuse, si bien que l'encombrement global est important, et forme un obstacle pour implanter le capteur et la portion de commande (ou surface tactile) dans des parties de faibles dimensions. L'ergonomie globale peut alors être affectée car seul un nombre limité de boutons de commande (ou surfaces tactiles) peuvent être implantés dans une poignée de surface limitée.

Le document EP 2355117 A1 décrit un capteur de détection d'un contact.

### Résumé

Conformément à la présente invention, un composant de capteur, selon la revendication 1 et un procédé de fabrication d'un capteur, selon la revendication 14 sont fournis. Des modes de réalisation préférés de l'invention sont revendiqués dans les revendications dépendantes.

### Exposé de l'invention

Un but de la présente invention est de répondre aux inconvénients de l'art antérieur mentionnés ci-dessus et en particulier, tout d'abord, de proposer un composant de capteur, et un capteur de détection qui permettent d'implanter des portions de commande (des surfaces tactiles) dans des parties de faibles dimensions d'un appareil électrique tout en conservant une possibilité d'éclairer ces portions de commande avec une source lumineuse disposée sur la carte électronique.

Pour cela un premier aspect de l'invention concerne un composant pour un capteur de détection d'un contact ou d'une proximité entre un utilisateur et une portion de commande d'un appareil électrique, ledit composant de capteur étant agencé pour relier ou connecter une carte électronique à la portion de commande, le composant de capteur comprenant :
- au moins un élément conducteur agencé pour se situer entre la carte électronique et la portion de commande et comprenant un corps élastique, agencé pour générer un effort de rappel entre la carte électronique et la portion de commande, et comprenant :
   - au moins une interface de connexion électrique avec la carte électronique, et
   - au moins une surface d'appui agencée pour être en regard de la carte électronique,
caractérisé en ce que le composant de capteur comprend :
- au moins une entretoise avec au moins une partie en matière isolante de l'électricité agencée au moins partiellement entre :
   - l'au moins une surface d'appui de l'élément conducteur, et
   - l'au moins une interface de connexion électrique de l'élément conducteur de manière à éloigner de la carte électronique les parties conductrices du corps élastique de l'élément conducteur autres que l'interface de connexion.

Autrement dit, l'élément conducteur est un ressort, et l'entretoise permet d'éviter tout contact entre les surfaces d'appui du ressort et la carte électronique. Le corps élastique est typiquement agencé entre la surface d'appui de l'élément conducteur et la surface d'appui secondaire de l'élément conducteur.

Cette disposition permet d'éloigner de la carte électronique les parties conductrices de l'élément conducteur 11 autres que l'interface de connexion de manière à permettre un routage de circuit imprimé sur une zone du circuit imprimé en regard de l'au moins une surface d'appui de l'élément conducteur.

Le composant de capteur selon la mise en œuvre ci-dessus comprend une entretoise isolante entre la carte électronique et l'élément conducteur, si bien que ce dernier ne touche plus la carte électronique autrement que via l'interface de connexion, et il n'est plus nécessaire de prévoir des pistes de circuit imprimé éloignées de l'élément conducteur. La carte électronique peut alors être rendue compacte et de faibles dimensions et rend possible l'insertion d'une source de lumière. La surface d'appui de l'élément conducteur se trouve en regard de la carte électronique, et l'élément conducteur peut comporter une surface d'appui secondaire, qui entre en appui avec la portion de commande par exemple.

Avantageusement, l'élément conducteur est agencé pour relier la carte électronique et la portion de commande. De manière préférée, l'élément conducteur est agencé pour procurer une portion conductrice à proximité ou en contact de la portion de commande, et reliée électriquement à la carte électronique. De manière schématique, la portion conductrice à proximité ou en contact de la portion de commande est une première extrémité de l'élément conducteur, et l'interface de connexion est une deuxième extrémité de l'élément conducteur.

Avantageusement, l'entretoise comprend une embase d'entretoise avec une première zone d'appui sur la carte électronique, et une deuxième zone d'appui agencée pour contacter la surface d'appui de l'élément conducteur.

Avantageusement, l'embase d'entretoise est réalisée avec un matériau diélectrique, tel qu'une matière plastique. On peut envisager de réaliser l'embase en matière polymère, par exemple en polyamide (PA, PA6-6, PA6-12), en acrylonitrile butadiène styrène (ABS), en polypropylène (PP), avec des fibres de renforcement si besoin.

Avantageusement, la première zone d'appui sur la carte électronique est formée par au moins deux, et de préférence trois, pieds d'appui distincts sur la carte électronique. De tels pieds permettent de limiter la surface d'appui de l'entretoise sur la carte électronique, de sorte à laisser plus de place pour les circuits imprimés.

Avantageusement, lesdits pieds d'appui présentent une surface d'appui inférieure à 30%, et de préférence inférieure à 20%, d'une surface projetée de l'entretoise sur la carte électronique. Cela permet de laisser de l'espace libre pour les circuits imprimés de la carte électronique.

Avantageusement, au moins deux des pieds d'appui sont agencés en périphérie de l'entretoise. La stabilité est améliorée.

Avantageusement, au moins deux des pieds d'appui sont répartis de part et d'autre d'un centre de l'entretoise. La stabilité est améliorée.

Avantageusement, l'entretoise comprend un corps d'entretoise, agencé dans le prolongement de l'embase et en regard de la portion de commande.

Avantageusement, le corps d'entretoise forme un cylindre agencé pour recevoir le corps de l'élément conducteur. Le corps forme un cylindre de positionnement pour l'élément conducteur, si bien que le composant de capteur est une pièce facile à assembler et à manipuler.

Avantageusement, le corps d'entretoise et l'embase d'entretoise forment une entretoise monobloc ou monolithique.

Avantageusement, l'entretoise comprend un trou central pour guider de la lumière vers la portion de commande, le trou central étant agencé pour être en regard d'une source de lumière de la carte électronique. Le trou central permet de limiter les fuites de lumière vers le reste de la carte électronique, et cela améliore le rendu visuel du système, car seule la portion de commande est illuminée ou rétroéclairée.

Avantageusement, l'entretoise comprend un évidement central évasé donnant sur le trou central, pour former un guide de lumière. On peut prévoir un revêtement ou une finition brillante pour guider efficacement la lumière vers la portion de commande.

Avantageusement, une périphérie du trou central est agencée pour entrer en appui sur la carte électronique.

Avantageusement, le composant de capteur comprend des moyens d'indexage de l'entretoise sur la carte électronique. La tenue et la position du composant sur la carte électronique sont alors bien définies.

Avantageusement, l'élément conducteur comprend au moins une patte de connexion formant l'interface de connexion électrique, et l'entretoise comprend une zone de guidage, agencée pour recevoir la patte de connexion. L'assemblage est facilité, avec un bon positionnement de la patte de connexion par l'entretoise.

Avantageusement, l'élément conducteur comprend deux pattes de connexion formant l'interface de connexion électrique.

Avantageusement, l'entretoise comprend :
- un siège, agencé pour recevoir l'élément conducteur, et/ou
- des moyens de retenue, agencés pour s'engager avec l'élément conducteur, pour retenir ce dernier. L'élément conducteur est fixé à demeure sur l'entretoise. On peut envisager un montage en force, ou un emboîtement élastique (clipsage). On peut aussi prévoir une patte de verrouillage pour maintenir en place l'élément conducteur sur l'entretoise.

Avantageusement, l'élément conducteur est un ressort hélicoïdal, encore appelé ressort à boudins.

Avantageusement, l'élément conducteur comprend au moins une extrémité recourbée, agencée pour s'engager avec une interface de connexion de la carte électronique.

Un second aspect de l'invention concerne un capteur de détection d'un contact ou d'une proximité entre un utilisateur et au moins une portion de commande d'un appareil électrique, comprenant :
- une carte électronique avec au moins un circuit électrique imprimé,
- au moins un composant de capteur selon le premier aspect de l'invention. Selon l'invention, on peut former plusieurs capteurs de détection avec la même carte électronique, il suffit de prévoir plusieurs circuits imprimés spécifiques, et autant de composants de capteur.

Avantageusement, les pieds d'appui sont agencés pour contacter la carte électronique entre des pistes de circuit imprimé. Il n'y a donc pas contact entre les pieds d'appui et les pistes de circuit, ce qui minimise les risques de détérioration.

Avantageusement, les pieds d'appui sont agencés pour former des ponts au dessus de pistes de circuit imprimé.

Avantageusement, au moins une piste de circuit imprimé est agencée entre deux pieds d'appui.

Avantageusement, la carte électronique comprend une source de lumière agencée pour émettre une lumière vers la portion de commande. On peut envisager une diode électroluminescente.

Avantageusement, les moyens d'indexage comprennent :
- au moins un index agencé sur l'une de l'entretoise ou de la carte électronique,
- au moins un trou de localisation agencé sur l'autre de l'entretoise ou de la carte électronique, pour recevoir l'index. La position relative entre le composant de capteur et la carte électronique est figée.

Avantageusement, le capteur de détection forme un capteur capacitif, dans lequel l'élément conducteur forme une antenne de détection. La portion de commande est un pavé tactile en matière isolante (une feuille de verre ou de plastique de quelques millimètres d'épaisseur), et la charge électrique ou la capacité de l'élément conducteur, placé sous la portion de commande, varie lorsque l'utilisateur approche ou contacte la portion de commande, ce qui permet une détection de contact ou de proximité.

Avantageusement, l'appareil électrique comprend une pluralité de portions de commandes distinctes, le capteur de détection comprenant :
- une pluralité de composant de capteurs selon le premier aspect de l'invention, chacun étant agencé entre la carte électronique et une des portions de commande distinctes. Cette mise en œuvre procure un capteur de détection multizones. On peut aussi considérer que plusieurs capteurs de détection sont alors fournis.

Avantageusement, au moins un de ladite pluralité de composant de capteurs comprend au moins deux éléments conducteurs et une entretoise agencée entre la carte électronique et lesdits au moins deux éléments conducteurs. Autrement dit, une entretoise peut porter plusieurs éléments conducteurs, ce qui limite les opérations de dépose sur la carte électronique.

Avantageusement, l'appareil électrique comprend une pluralité de portions de commandes distinctes, le capteur de détection comprenant :
- un composant de capteur selon le premier aspect de l'invention qui comprend autant d'éléments conducteurs que de portions de commande distinctes et une seule entretoise agencée entre la carte électronique et lesdits éléments conducteurs. Cette mise en œuvre procure un capteur de détection multizones. On peut aussi considérer que plusieurs capteurs de détection sont alors fournis, avec une seule entretoise.

Un troisième aspect de l'invention concerne un appareil électrique électroménager, comprenant au moins une portion de commande et au moins un capteur de détection selon le deuxième aspect de l'invention. Avantageusement, l'appareil électrique électroménager comprend :
- une poignée à saisir par un utilisateur,
- une pluralité de portions de commande,
- une pluralité de capteurs de détection selon le deuxième aspect de l'invention,
dans lequel la pluralité de portions de commande est agencée sur, ou au niveau de la poignée. Le volume disponible au niveau de la poignée est typiquement limité, mais le composant de capteur selon l'invention permet d'agencer les pistes de circuit imprimé proches les unes des autres, sous l'entretoise, si bien que la carte électronique peut présenter un faible encombrement, compatible avec l'espace disponible dans la poignée. En résumé, la carte électronique avec tous ses capteurs de détection se trouve sous les portions de commandes, dans la poignée.

Avantageusement, les portions de commande sont alignées le long de la poignée.

Avantageusement, ladite au moins une portion de commande comprend au moins une paroi transparente ou translucide.

Avantageusement, l'appareil électrique électroménager forme un appareil de cuisson, tel qu'un appareil à grillades.

Un dernier aspect de l'invention concerne un procédé de fabrication d'un capteur de détection selon le deuxième aspect de l'invention, comprenant une étape consistant à assembler l'élément conducteur sur l'entretoise pour former un composant de capteur selon le premier aspect, et une étape consistant à déposer le composant de capteur sur la carte électronique, avec des moyens de manipulation automatisés, tels qu'un robot, et/ou un manipulateur automatique, et/ou un bol vibrant, et/ou des moyens de préhensions pneumatiques tels qu'une pince. L'entretoise et l'élément conducteur forment un composant de capteur aisé à manipuler, en comparaison de l'élément conducteur seul (un ressort), si bien qu'on peut automatiser les opérations de dépose (habituellement manuelle) sur la carte.

En résumé de la présente demande :
- le composant de capteur comprend au moins l'élément conducteur et une entretoise,
- le capteur de détection comprend le composant de capteur et la carte électronique dont un circuit comprend l'élément conducteur (la carte électronique embarquant aussi les composants électroniques nécessaires pour analyser des variations de signal de tension ou de courant ou de capacité du circuit comprenant l'élément conducteur),
- l'appareil électrique comprend une ou plusieurs portion(s) de commande(s) et le même nombre de capteur(s) de détection. Cependant, il est possible de considérer que la portion de commande fait partie du capteur de détection.

### Description des figures

D'autres caractéristiques et avantages de la présente invention apparaîtront plus clairement à la lecture de la description détaillée qui suit d'un mode de réalisation de l'invention donné à titre d'exemple nullement limitatif et illustré par les dessins annexés, dans lesquels :
[Fig 1]

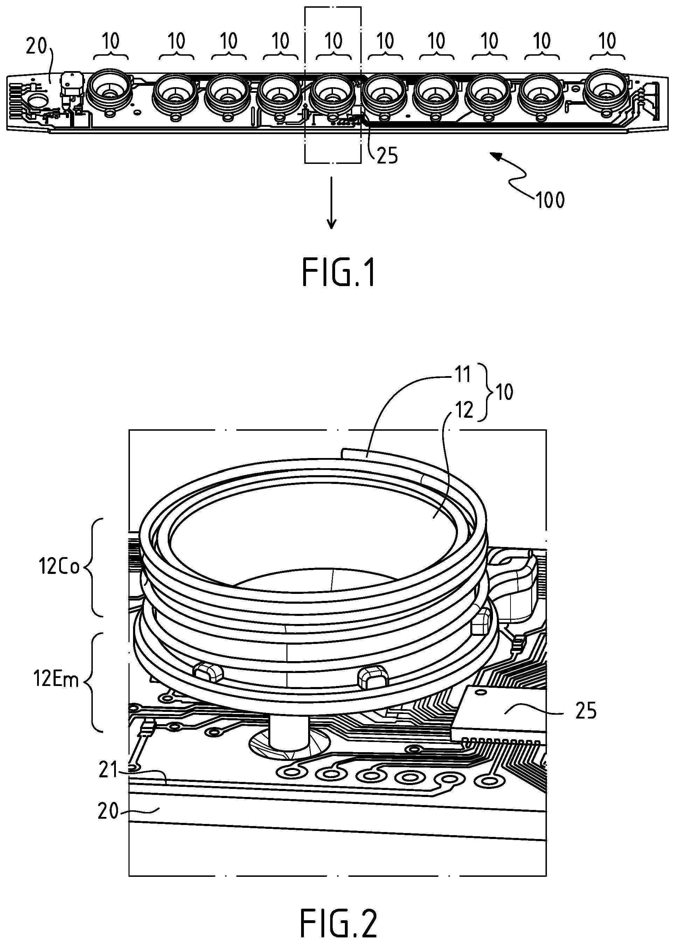

   La figure 1 représente une carte électronique avec une pluralité de composants de capteur, formant ainsi une pluralité de capteurs de détection ;
[Fig 2]
   La figure 2 représente en détail la carte électronique et un composant de capteur de la figure 1 ;
[Fig 3]

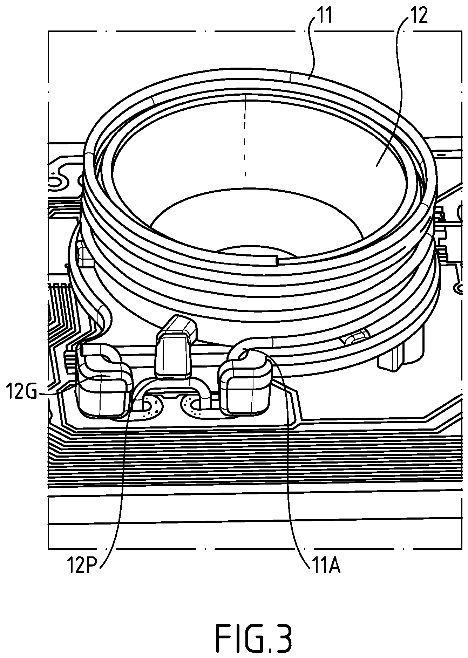

   La figure 3 représente une vue arrière de la vue représentée figure 2 ;
[Fig 4]

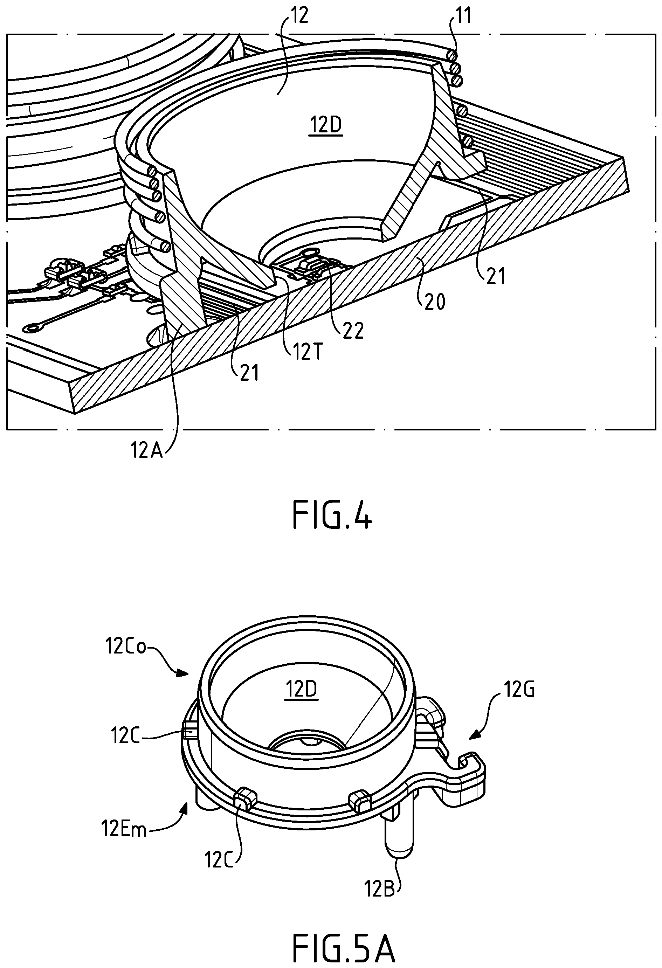

   La figure 4 représente une coupe de la carte électronique et du composant de capteur de la figure 2 ;
[Fig 5A]
   La figure 5A représente une vue en perspective d'une entretoise du composant de capteur de la figure 2 et 3 ;
[Fig 5B]

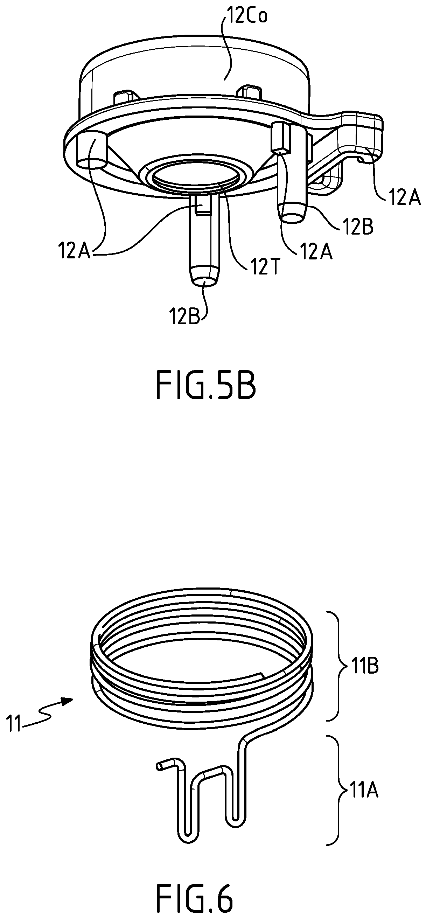

   La figure 5B représente une autre vue en perspective de l'entretoise du composant de capteur de la figure 2 et 3 ;
[Fig 6]
   La figure 6 représente une vue en perspective d'un élément conducteur du composant de capteur de la figure 2 et 3.

### Description détaillée de mode(s) de réalisation

La figure 1 représente une vue en perspective d'un sous ensemble électronique 100 composé notamment d'une carte électronique 20 comprenant des circuits imprimés 21, des composants électroniques 25 et équipée de dix composants de capteur 10 selon l'invention, de sorte à former des capteurs de détection d'une proximité ou d'un contact avec une portion de commande d'un appareil électrique (non représentés).

L'appareil électrique en question est typiquement un appareil électroménager, et en particulier un appareil de cuisson, comme un appareil à grillades. Un tel appareil électrique comprend une interface homme machine avec des boutons de commande, et il est avantageux de prévoir ces boutons de commande avec une portion de commande qui est une paroi lisse, telle qu'une vitre d'une épaisseur de quelques millimètres (entre 2 mm et 6 mm), ou une paroi en plastique d'une épaisseur de quelques millimètres (entre 2 mm et 4 mm).

Les boutons de commande sont alors des capteurs de détection d'un contact ou d'une proximité d'un membre de l'utilisateur (un doigt) avec la portion de commande. On peut utiliser des capteurs de détection capacitifs (fonctionnement basé sur une variation de capacité d'un élément généralement conducteur du capteur de détection), ou des capteurs de détection résistifs (fonctionnement basé sur une variation de résistance d'un élément du capteur de détection).

Le sous ensemble électronique 100 de la figure 1 est donc agencé sous la portion de commande de l'appareil électrique (la vitre ou la paroi plastique) pour former dix capteurs de détection d'un contact ou d'une proximité d'un membre de l'utilisateur (un doigt) avec des zones de la portion de commande en regard de chacun de composants de capteur 10.

Comme bien visible sur la figure 2, chaque composant de capteur 10 posé sur la carte électronique 20 se compose d'un élément conducteur 11 et d'une entretoise 12. L'élément conducteur 11 est par exemple un élément élastique réalisé en métal, en acier ou en cuivre. L'entretoise 12 est quant à elle une pièce monolithique réalisée en matière plastique, par exemple en polymère, par exemple en polyamide (PA, PA6-6, PA6-12), en acrylonitrile butadiène styrène (ABS), en polypropylène (PP), avec des fibres de renforcement si besoin, telles que des fibres de verre à 30% en poids.

L'élément conducteur 11, représenté seul sur la figure 6, comprend une interface de connexion 11A pour se connecter électriquement avec la carte électronique 20, et un corps élastique 11B, et vient toucher la portion de commande (la face interne de la vitre ou de la paroi plastique). En résumé, l'élément conducteur 11 est connecté à un des circuits imprimés 21 de la carte électronique 20, et forme l'élément sensible d'un capteur capacitif, ou un élément de connexion électrique d'un capteur résistif.

L'élément conducteur 11 présente ici la forme d'un ressort à boudins et le corps élastique 11B (ici de forme généralement cylindrique) permet de garantir que l'élément conducteur sera toujours en appui sur la portion de commande en exerçant un effort sur la carte électronique.

Cependant, il est important que la carte électronique 20 présente de faibles dimensions pour pouvoir être intégrée aisément dans l'appareil électrique, par exemple dans une poignée.

A cet effet, le composant de capteur comprend une entretoise 12 isolante de l'électricité qui comprend une embase d'entretoise 12Em en partie inférieure sur la figure 2, et un corps d'entretoise 12Co en partie supérieure sur la figure 2. L'embase d'entretoise 12Em est intercalée entre la partie d'appui de l'élément conducteur 11 (la base du corps élastique 11B) et la carte électronique 20 et présente des pieds d'appuis 12A (visibles figures 5A et 5B) sur la carte électronique 20. En conséquence, l'élément conducteur 11 ne contacte la carte électronique 20 que via son interface de connexion 11A, ce qui permet de définir un agencement des circuits imprimés 21 même en regard de l'élément conducteur 11 et de son corps élastique 11B. En d'autres termes, l'embase d'entretoise 12Em permet d'éloigner de la carte électronique 20 les parties conductrices du corps élastique 11B de l'élément conducteur 11 autres que l'interface de connexion 11A, si bien que l'on peut prévoir un routage de circuit imprimé "sous" l'élément conducteur 11, sur une zone du circuit imprimé en regard de l'au moins une surface d'appui de l'élément conducteur, sans requérir un contournement, ce qui permet de rendre la carte électronique 20 compacte.

En particulier, l'embase d'entretoise 12Em comprend plusieurs pieds d'appui 12A qui forment une première zone d'appui sur la carte électronique 20 et des protubérances 12C visibles figure 5A et qui forment une deuxième zone d'appui pour recevoir la surface d'appui de l'élément conducteur 11, ce qui permet de décaler l'élément conducteur 11 de la carte électronique 20.

De plus, les pieds d'appui 12A sont distincts et éloignés les uns des autres, si bien qu'il est possible de faire passer des pistes de circuit imprimé 21 entre les pieds d'appui 12A, comme on le voit figure 2 ou figure 3 ou encore figure 4.

En ce qui concerne le corps d'entretoise 12Co, ce dernier est agencé pour recevoir et centrer le corps élastique 11B, et l'entretoise 12 comprend également une zone de guidage 12G visible figures 3 et 5A pour recevoir l'interface de connexion 11A. Il est également prévu une patte 12P visible figure 3, pour retenir l'élément conducteur 11 sur l'entretoise 12. En conséquence, le composant de capteur forme un composant unitaire qui peut être aisément manipulé, même avec des moyens de préhension automatisés (un robot, des moyens de préhension pneumatiques, un manipulateur...) pour effectuer la dépose sur la carte électronique 20.

Pour bien garantir la position du composant de capteur sur la carte électronique 20, des moyens d'indexage sont prévus et réalisés dans le présent exemple avec des pions de guidage 12B implantés sur l'entretoise 12, qui viennent s'engager dans des trous de guidage de la carte électronique 20.

On peut prévoir une signalisation lumineuse pour aider l'utilisateur à localiser les portions de commandes sur l'appareil électrique. A cet effet, la carte électronique 20 embarque des diodes électroluminescentes 22 visibles figure 4, et il est prévu un trou 12T au centre de l'entretoise 12, ainsi qu'un évidement central évasé 12D pour laisser passer et guider la lumière vers la portion de commande, qui est par exemple une paroi au moins partiellement transparente ou translucide (du verre ou du plastique comme vu ci-dessus).

On peut prévoir un revêtement brillant sur la forme évasée 12D, ou un état de surface lisse pour améliorer la transmission de lumière. En tout état de cause, le trou 12T et l'évasement central 12D évitent les fuites latérales de lumière, ce qui augmente la lisibilité pour l'utilisateur.

### Application industrielle

Les composants de capteur, les capteurs de détection et l'appareil électrique décrits dans la présente divulgation sont susceptibles d'application industrielle.

On comprendra que diverses modifications et/ou améliorations évidentes pour l'homme du métier peuvent être apportées aux différents modes de réalisation de l'invention décrits dans la présente description sans sortir du cadre de l'invention défini par les revendications annexées.

## Revendications

1. Composant de capteur (10) pour un capteur de détection d'un contact ou d'une proximité entre un utilisateur et une portion de commande d'un appareil électrique, ledit composant de capteur étant agencé pour relier ou connecter une carte électronique (20) à la portion de commande, le composant de capteur (10) comprenant :
• au moins un élément conducteur (11) agencé pour se situer entre la carte électronique (20) et la portion de commande et comprenant un corps élastique (11B), agencé pour générer un effort de rappel entre la carte électronique (20) et la portion de commande, et comprenant :
- au moins une interface de connexion (11A) électrique avec la carte électronique (20), et
- au moins une surface d'appui agencée pour être en regard de la carte électronique (20),
• au moins une entretoise (12) avec au moins une partie en matière isolante de l'électricité agencée au moins partiellement entre :
- l'au moins une surface d'appui de l'élément conducteur (11), et
- l'au moins une interface de connexion (11A) électrique de l'élément conducteur (11)
de manière à éloigner de la carte électronique (20) les parties conductrices du corps élastique (11B) de l'élément conducteur (11) autres que l'interface de connexion ;
dans lequel l'entretoise (12) comprend une embase d'entretoise (12Em) avec une première zone d'appui sur la carte électronique (20), et une deuxième zone d'appui agencée pour contacter la surface d'appui de l'élément conducteur (11) ;
**caractérisé en ce que** la première zone d'appui sur la carte électronique (20) est formée par au moins deux, et de préférence trois, pieds d'appui (12A) distincts sur la carte électronique (20), lesdits pieds d'appui (12A) présentant une surface d'appui inférieure à 30%, et de préférence inférieure à 20%, d'une surface projetée de l'entretoise (12) sur la carte électronique (20).

2. Composant de capteur (10) selon la revendication 1, dans lequel au moins deux des pieds d'appui (12A) sont répartis de part et d'autre d'un centre de l'entretoise (12).

3. Composant de capteur (10) selon l'une des revendications précédentes, dans lequel l'entretoise (12) comprend un trou (12T) central pour guider de la lumière vers la portion de commande, le trou (12T) central étant agencé pour être en regard d'une source de lumière de la carte électronique (20).

4. Composant de capteur (10) selon la revendication précédente, dans lequel l'entretoise (12) comprend un évidement central évasé (12D) donnant sur le trou (12T) central, pour former un guide de lumière.

5. Composant de capteur (10) selon l'une des revendications précédentes, comprenant des moyens d'indexage de l'entretoise (12) sur la carte électronique (20).

6. Composant de capteur (10) selon l'une des revendications précédentes, dans lequel l'élément conducteur (11) comprend au moins une patte de connexion formant l'interface de connexion (11A) électrique, et dans lequel l'entretoise (12) comprend une zone de guidage (12G), agencée pour recevoir la patte de connexion.

7. Composant de capteur (10) selon l'une des revendications précédentes, dans lequel l'élément conducteur (11) est un ressort hélicoïdal.

8. Capteur de détection d'un contact ou d'une proximité entre un utilisateur et au moins une portion de commande d'un appareil électrique, comprenant :
- une carte électronique (20) avec au moins un circuit électrique imprimé,
- au moins un composant de capteur (10) selon l'une des revendications précédentes.

9. Capteur de détection selon la revendication précédente, dans lequel les pieds d'appui (12A) sont agencés pour contacter la carte électronique (20) entre des pistes de circuit imprimé.

10. Capteur de détection selon l'une des revendications 8 ou 9, formant un capteur capacitif, dans lequel l'élément conducteur (11) forme une antenne de détection.

11. Appareil électrique électroménager, comprenant au moins une portion de commande et au moins un capteur de détection selon l'une des revendications 8 à 10.

12. Appareil électrique électroménager selon la revendication précédente, comprenant :
- une poignée à saisir par un utilisateur,
- une pluralité de portions de commande,
- une pluralité de capteurs de détection selon l'une des revendications 8 à 10,
dans lequel la pluralité de portions de commande est agencée sur, ou au niveau de la poignée.

13. Appareil électrique électroménager selon l'une des revendications 11 ou 12, formant un appareil de cuisson, tel qu'un appareil à grillades.

14. Procédé de fabrication d'un capteur de détection selon l'une des revendications 8 à 10, comprenant une étape consistant à assembler l'élément conducteur sur l'entretoise pour former un composant de capteur selon l'une des revendications 1 à 7, et une étape consistant à déposer le composant de capteur sur la carte électronique, avec des moyens de manipulation automatisés, tels qu'un robot, et/ou un manipulateur automatique, et/ou un bol vibrant, et/ou des moyens de préhensions pneumatiques tels qu'une pince.

## Patentansprüche

1. Sensorkomponente (10) für einen Sensor zur Erfassung eines Kontakts oder einer Nähe zwischen einem Benutzer und einem Bedienabschnitt eines elektrischen Geräts, wobei die Sensorkomponente dazu eingerichtet ist, eine elektronische Leiterplatte (20) mit dem Bedienabschnitt zu verbinden oder zu koppeln, wobei die Sensorkomponente (10) umfasst:
• mindestens ein Leiterelement (11), das dazu eingerichtet ist, zwischen der elektronischen Leiterplatte (20) und dem Bedienabschnitt angeordnet zu sein und einen elastischen Körper (11B) umfasst, der dazu eingerichtet ist, eine Rückstellkraft zwischen der elektronischen Leiterplatte (20) und dem Bedienabschnitt zu erzeugen, und umfasst:
- mindestens eine elektrische Anschlussstelle (11A) zur elektronischen Leiterplatte (20), und
- mindestens eine Auflagefläche, die dazu eingerichtet ist, der elektronischen Leiterplatte (20) gegenüberzuliegen,
• mindestens einen Abstandshalter (12) mit mindestens einem elektrisch isolierenden Materialabschnitt, der zumindest teilweise angeordnet ist zwischen:
- der mindestens einen Auflagefläche des Leiterelements (11), und
- der mindestens einen elektrischen Anschlussstelle (11A) des Leiterelements (11), um die leitenden Bereiche des elastischen Körpers (11B) des Leiterelements (11), mit Ausnahme der Anschlussstelle, von der elektronischen Leiterplatte (20) abzurücken; wobei der Abstandshalter (12) einen Abstandshaltersockel (12Em) mit einem ersten Auflagebereich auf der elektronischen Leiterplatte (20) und einem zweiten Auflagebereich umfasst, der dazu eingerichtet ist, mit der Auflagefläche des Leiterelements (11) in Kontakt zu treten; **dadurch gekennzeichnet, dass** der erste Auflagebereich auf der elektronischen Leiterplatte (20) durch mindestens zwei, und vorzugsweise drei, voneinander getrennte Stützfüße (12A) auf der elektronischen Leiterplatte (20) gebildet ist, wobei die Stützfüße (12A) eine Auflagefläche aufweisen, die kleiner als 30 %, und vorzugsweise kleiner als 20 %, einer projizierten Fläche des Abstandshalters (12) auf der elektronischen Leiterplatte (20) ist.Sensor component (10) according to claim 1, wherein at least two of the support feet (12A) are distributed on either side of a centre of the spacer (12).

2. Sensorkomponente (10) nach Anspruch 1, wobei mindestens zwei der Stützfüße (12A) beidseits eines Zentrums des Abstandshalters (12) verteilt sind.

3. Sensorkomponente (10) nach einem der vorhergehenden Ansprüche, wobei der Abstandshalter (12) ein zentrales Loch (12T) zum Führen von Licht zu dem Bedienabschnitt aufweist, wobei das zentrale Loch (12T) dazu eingerichtet ist, einer Lichtquelle der elektronischen Leiterplatte (20) gegenüberzuliegen.

4. Sensorkomponente (10) nach dem vorhergehenden Anspruch, wobei der Abstandshalter (12) eine sich erweiternde zentrale Ausnehmung (12D) aufweist, die in das zentrale Loch (12T) mündet, um einen Lichtleiter zu bilden.

5. Sensorkomponente (10) nach einem der vorhergehenden Ansprüche, umfassend Indexiermittel zum Ausrichten des Abstandshalters (12) auf der elektronischen Leiterplatte (20).

6. Sensorkomponente (10) nach einem der vorhergehenden Ansprüche, wobei das Leiterelement (11) mindestens einen Anschlusslappen umfasst, der die elektrische Anschlussstelle (11A) bildet, und wobei der Abstandshalter (12) einen Führungsbereich (12G) aufweist, der dazu eingerichtet ist, den Anschlusslappen aufzunehmen.

7. Sensorkomponente (10) nach einem der vorhergehenden Ansprüche, wobei das Leiterelement (11) eine Schraubenfeder ist.

8. Sensor zur Erfassung eines Kontakts oder einer Nähe zwischen einem Benutzer und mindestens einem Bedienabschnitt eines elektrischen Geräts, umfassend:
- eine elektronische Leiterplatte (20) mit mindestens einer gedruckten elektrischen Schaltung,
- mindestens eine Sensorkomponente (10) nach einem der vorhergehenden Ansprüche.

9. Erfassungssensor nach dem vorhergehenden Anspruch, wobei die Stützfüße (12A) dazu eingerichtet sind, die elektronische Leiterplatte (20) zwischen Leiterbahnen der gedruckten Schaltung zu kontaktieren.

10. Erfassungssensor nach einem der Ansprüche 8 oder 9, der einen kapazitiven Sensor bildet, wobei das Leiterelement (11) eine Erfassungsantenne bildet.

11. elektrisches Haushaltsgerät, umfassend mindestens einen Bedienabschnitt und mindestens einen Erfassungssensor nach einem der Ansprüche 8 bis 10.

12. elektrisches Haushaltsgerät nach dem vorhergehenden Anspruch, umfassend:
- einen von einem Benutzer zu greifenden Griff,
- eine Vielzahl von Bedienabschnitten,
- eine Vielzahl von Erfassungssensoren nach einem der Ansprüche 8 bis 10, wobei die Vielzahl von Bedienabschnitten auf dem Griff oder in dessen Bereich angeordnet ist.

13. elektrisches Haushaltsgerät nach einem der Ansprüche 11 oder 12, das ein Kochgerät bildet, wie beispielsweise ein Grillgerät.

14. Verfahren zur Herstellung eines Erfassungssensors nach einem der Ansprüche 8 bis 10, umfassend einen Schritt, der darin besteht, das Leiterelement mit dem Abstandshalter zu einem Sensorkomponente nach einem der Ansprüche 1 bis 7 zusammenzubauen, und einen Schritt, der darin besteht, die Sensorkomponente mit automatisierten Handhabungsmitteln, wie einem Roboter und/oder einem automatischen Manipulator und/oder einer Schwingförderrinne und/oder pneumatischen Greifmitteln wie einer Zange, auf der elektronischen Leiterplatte abzulegen.

## Claims

1. Sensor component (10) for a sensor for detecting a contact or a proximity between a user and a control portion of an electric appliance, said sensor component being arranged to link or connect an electronic board (20) to the control portion, the sensor component (10) comprising:
• at least one conductive element (11) arranged to be located between the electronic board (20) and the control portion and comprising an elastic body (11B), arranged to generate a return force between the electronic board (20) and the control portion, and comprising:
- at least one electrical connection interface (11A) with the electronic board (20), and
- at least one bearing surface arranged to face the electronic board (20),
• at least one spacer (12) with at least one part made of electrically insulating material arranged at least partially between:
- the at least one bearing surface of the conductive element (11), and
- the at least one electrical connection interface (11A) of the conductive element (11) so as to move away from the electronic board (20) the conductive parts of the elastic body (11B) of the conductive element (11) other than the connection interface; wherein the spacer (12) comprises a spacer base (12Em) with a first bearing area on the electronic board (20), and a second bearing area arranged to contact the bearing surface of the conductive element (11); **characterised in that** the first bearing area on the electronic board (20) is formed by at least two, and preferably three, distinct support feet (12A) on the electronic board (20), said support feet (12A) having a bearing surface of less than 30%, and preferably of less than 20%, of a projected surface of the spacer (12) on the electronic board (20).

2. Sensor component (10) according to claim 1, wherein at least two of the support feet (12A) are distributed on either side of a centre of the spacer (12).

3. Sensor component (10) according to any one of the preceding claims, wherein the spacer (12) comprises a central hole (12T) for guiding light towards the control portion, the central hole (12T) being arranged to face a light source of the electronic board (20).

4. Sensor component (10) according to the preceding claim, wherein the spacer (12) comprises a flared central recess (12D) opening onto the central hole (12T), in order to form a light guide.

5. Sensor component(10) according to any one of the preceding claims, comprising indexing means for indexing the spacer (12) on the electronic board (20).

6. Sensor component (10) according to any one of the preceding claims, wherein the conductive element (11) comprises at least one connection lug forming the electrical connection interface (11A), and wherein the spacer (12) comprises a guiding area (12G), arranged to receive the connection lug.

7. Sensor component (10) according to any one of the preceding claims, wherein the conductive element (11) is a helical spring.

8. Sensor for detecting a contact or a proximity between a user and at least one control portion of an electric appliance, comprising:
- an electronic board (20) with at least one printed electric circuit,
- at least one sensor component (10) according to any one of the preceding claims.

9. Detection sensor according to the preceding claim, wherein the support feet (12A) are arranged to contact the electronic board (20) between printed circuit tracks.

10. Detection sensor according to either claim 8 or 9, forming a capacitive sensor, wherein the conductive element (11)forms a detection antenna.

11. Electric household appliance, comprising at least one control portion and at least one detection sensor according to any one of claims 8 to 10.

12. Electric household appliance according to the preceding claim, comprising:
- a handle to be grasped by a user,
- a plurality of control portions,
- a plurality of detection sensors according to any one of claims 8 to 10, wherein the plurality of control portions is arranged on, or at the level of, the handle.

13. Electric household appliance according to either claim 11 or 12, forming a cooking appliance, such as a grilling appliance.

14. Method of manufacturing a detection sensor according to any one of claims 8 to 10, comprising a step consisting in assembling the conductive element on the spacer to form a sensor component according to any one of claims 1 to 7, and a step consisting in depositing the sensor component on the electronic board, with automated handling means, such as a robot, and/or an automatic manipulator, and/or a vibratory bowl, and/or pneumatic gripping means such as a clamp.
